# EUROPEAN PATENT SPECIFICATION

(11) **EP 4 439 232 B1**
(45) Date of publication and mention of the grant of the patent: **01.04.2026**
(21) Application number: 22939888.8
(22) Date of filing: 29.11.2022
(51) Int. Cl.: G06F 1/20, G06F 1/18, H05K 7/20

(54) **SERVER HEAT DISSIPATION CONTROL DEVICE AND SERVER HEAT DISSIPATION CONTROL METHOD**
VORRICHTUNG ZUR STEUERUNG DER SERVERWÄRMEABLEITUNG UND VERFAHREN ZUR STEUERUNG DER SERVERWÄRMEABLEITUNG
DISPOSITIF DE COMMANDE DE DISSIPATION DE CHALEUR DE SERVEUR ET PROCÉDÉ DE COMMANDE DE DISSIPATION DE CHALEUR DE SERVEUR

(30) Priority: 29.04.2022 CN 202210462562
(43) Date of publication of application: 02.10.2024
(73) Proprietor: Suzhou Metabrain Intelligent Technology Co., Ltd., Suzhou, Jiangsu 215000 (CN)
(72) Inventor: ZHU, Huanlai, Suzhou, Jiangsu 215000 (CN)
(74) Representative: Dennemeyer & Associates S.A.
(86) International application number: PCT/CN2022/135156
(87) International publication number: WO 2023/207074

(56) References cited:
- AU-A1- 2019 343 158
- CN-A- 113 056 167
- CN-A- 113 675 497
- CN-A- 114 578 934
- JP-A- H03 229 493
- US-A1- 2020 393 206
- US-A1- 2020 393 206
- US-A1- 2021 059 079
- US-A1- 2021 219 455

## Description

### Technical Field

The present invention relates to the technical field of servers, and in particular, to a control device for a heat dissipation of a server. The present invention further relates to a method for controlling heat dissipation of a server, which is applied to the control device for the heat dissipation of the server.

### Background

Currently, in order to meet the ever-increasing computing power requirements of data centers, the power density of a single cabinet is becoming higher and higher. Under this context, heat dissipation technologies for liquid-cooled data centers with low PUE (abbreviation for Power Usage Effectiveness, which is an index for evaluating an energy efficiency of a data center) and high heat dissipation density emerge as required.

In a related art, a two-phase immersion liquid-cooled system uses a latent heat of vaporization phase change of a heat dissipation working medium to carry away heat quickly, which undoubtedly has a highest cooling efficiency and a highest heat dissipation density. In the two-phase immersion liquid-cooled system, a thermally-conductive engineering liquid (the heat dissipation working medium), such as a fluorinated liquid, needs to be arranged in an enclosed box body, and a server in the enclosed box body is immersed in the engineering liquid to achieve heat dissipation. However, when maintenance of the server is required, it is necessary to open a cover plate of the enclosed box body, which causes a leakage of the fluorinated liquid, leading to economic loss and safety risks caused by a large amount of leakage of the expensive fluorinated liquid.

A mitigating vapor loss in a two-phase immersion cooling system is disclosed in D1 (US 2021/059079 A1);
A immersion cooling module and electronic apparatus having the same is disclosed in D2 (US 2020/393206 A1);
A liquid immersion cooling system is disclosed in D3 (AU 2019 343 158 A1);
A method and system for in-situ measuring of a heat transfer fluid in a device for immersion cooling and device for immersion cooling is disclosed in D4 (US 2021/219455 A1).

### Summary

The invention is set out in the appended set of claims.

An object of some embodiments of the present invention is to provide a control device for the control device for a heat dissipation of a server, configured for heat dissipation of the server and comprising:
a box body;
a cover plate, connected with the box body and configured to close the box body;
a heat dissipation working medium, arranged in the box body and configured to immerse the server; and
a condensing module, arranged in the box body and comprising:
   a condensing coil, arranged in the box body and configured to assist phase change of the heat dissipation working medium, so as to achieve heat dissipation circulation; and
   a flow guide driving member, arranged towards the condensing coil and configured to provide a driving force to control a gaseous heat dissipation working medium to flow towards the condensing coil, so as to prevent the gaseous heat dissipation working medium from impacting the cover plate when the cover plate is closed and prevent the gaseous heat dissipation working medium from leaking to an outside of the box body when the cover plate is opened;
   wherein the condensing module further comprises a gas-liquid separator; the gas-liquid separator is arranged at an outlet of the flow guide driving member, and the gas-liquid separator is configured to separate an air and a droplet-shaped heat dissipation working medium;
   the device further comprises a ventilation valve, wherein the ventilation valve is arranged on the cover plate, and an air separated by the gas-liquid separator is discharged out of the box body through the ventilation valve

In some embodiments, the flow guide driving member is arranged at a side close to an inlet of the condensing coil.

In some embodiments, an accommodating space is formed between the condensing coil and the box body, the flow guide driving member is arranged in the accommodating space, and the condensing coil covers the flow guide driving member in an arrangement direction of the server.

In some embodiments, the condensing coil is an S-shaped coil.

In some embodiments, the gas-liquid separator comprises a first baffle plate and a second baffle plate; the first baffle plate is connected with the flow guide driving member, and the second baffle plate is connected with the first baffle plate and is arranged at a preset included angle relative to the first baffle plate.

In some embodiments, the device further comprises:
a first pressure sensor, arranged between the cover plate and the box body and configured to detect a state of the cover plate;
a second pressure sensor, arranged on the cover plate and configured to measure a pressure in the box body; and
a control assembly, connected with the first pressure sensor, the second pressure sensor and the flow guide driving member, and configured to control an operation of the flow guide driving member according to pressure values measured by the first pressure sensor and the second pressure sensor.

In some embodiments, the device further comprises a pressure regulating valve, wherein the pressure regulating valve is arranged on the cover plate and is connected to the control assembly, and the pressure regulating valve is configured to regulate the pressure inside the box body.

Some embodiments of the present invention further provide a method for controlling heat dissipation of a server, applied to the control device for the heat dissipation of a server of any one above and comprising:
it is determined whether the cover plate on the box body is closed;
if the cover plate is closed, it is determined whether a pressure in the box body is a first normal value;
if it is determined that the pressure in the box body is not the first normal value, the flow guide driving member is controlled to operate; after the heat dissipation working medium flows towards the condensing coil and is condensed by the condensing coil, the air and droplet-shaped heat dissipation working medium flow to the gas-liquid separator through the outlet of the flow guide driving member; the gas-liquid separator separates the air from the droplet-shaped heat dissipation working medium, and the air is discharged upwards out of the box body, so that the pressure in the box body is adjusted to the first normal value; and
if the cover plate is opened, it is determined whether the pressure in the box body is a second normal value; and
if the pressure in the box body is not the second normal value, the flow guide driving member is controlled to operate; after the heat dissipation working medium flows towards the condensing coil and is condensed by the condensing coil, the air and droplet-shaped heat dissipation working medium flow to the gas-liquid separator through the outlet of the flow guide driving member; the gas-liquid separator separates the air from the droplet-shaped heat dissipation working medium, and the air is discharged upwards out of the box body, so that the pressure in the box body is adjusted to the second normal value.

With respect to the background, a control device for a heat dissipation of a server provided in embodiments of the present invention is configured for heat dissipation of the server. The device specifically includes a box body, a cover plate, a heat dissipation working medium and a condensing module, wherein the server is arranged in the box body, the cover plate is connected with the box body, and the cover plate is configured to close the box body so as to improve an enclosed space for a heat dissipation circulation of the server; the heat dissipation working medium is arranged in the box body, and the server is immersed in the heat dissipation working medium, for heat dissipation of the server; and the condensing module is arranged in the box body. In some embodiments, the condensing module specifically includes a condensing coil, a flow guide driving member and a gas-liquid separator, wherein the condensing coil is arranged in the box body, the condensing coil is configured to assist phase change of the heat dissipation working medium, so as to achieve heat dissipation circulation. The phase change refers to a process in which the heat dissipation working medium vaporized into a gas state is condensed into a liquid after releasing heat on the condensing coil; the heat dissipation working medium condensed into the liquid state falls back into the box body under an action of gravity, thereby achieving the heat dissipation circulation; and the flow guide driving member is arranged towards the condensing coil, and the flow guide driving member is configured to provide a driving force to control the heat dissipation working medium in a steam/gas state to flow towards the condensing coil; and the gas-liquid separator is arranged at an outlet of the flow guide driving member, and the gas-liquid separator is configured to separate an air and a droplet-shaped heat dissipation working medium. In this way, the following beneficial effects are able to be brought about:
firstly, a gaseous heat dissipation working medium is able to be sufficiently condensed on the condensing coil, thereby greatly increasing the condensation efficiency;
secondly, the gaseous heat dissipation working medium is able to be prevented from impacting the cover plate when the cover plate is closed; if the heat dissipation working medium impacts the cover plate and then rebounds back and flows to the condensing module, the pressure loss will be increased, which is equivalent to increasing the temperature drop of the steam and indirectly decreasing the condensation efficiency, and therefore the gaseous heat dissipation working medium is able to be prevented from impacting the cover plate, thereby further increasing the condensation efficiency;
thirdly, the gaseous heat dissipation working medium is able to be prevented from leaking to an outside of the box body when the cover plate is opened; that is to say, a flowing direction of the heat dissipation working medium is changed by the flow guide driving member, so as to prevent the heat dissipation working medium from leaking to the outside of the box body; and
fourthly, in the embodiments of the present invention, on a basis of providing the condensing coil and the flow guide driving member, flow guide driving of fluorinated liquid steam is achieved by the flow guide driving member, thus, a guided fluorinated liquid steam is completely condensed on the condensing coil, an outlet position of the flow guide driving member mainly comprises small-particle droplets of the fluorinated liquid and a small amount of air, and the outlet of the flow guide driving member is provided with the gas-liquid separator. Due to different densities of gas and liquid, when a mixed flow encounters an obstacle, the gas will be diverted and flow away; the liquid has a continuous forward speed due to inertia, the forward liquid is attached to the gas-liquid separator, and is gathered together downwards due to an action of gravity, and finally drops back to an inside of the box body; however, the air will be diverted and flow upward due to the small density thereof, and is discharged to the outside of the box body through a top of the box body, so that the pressure in the box body is able to be always maintained at a normal value, which facilitates to ensure the stability of the operation of the system.

In addition, the method for controlling heat dissipation of a server provided by the embodiments of the present invention is applied to the control device for the heat dissipation of the server, and includes: it is determined whether the cover plate on the box body is closed; if the cover plate is closed, it is determined whether the pressure in the box body is the first normal value; if it is determined that the pressure in the box body is not the first normal value, the flow guide driving member is controlled to operate; after the heat dissipation working medium flows towards a condensing coil and is condensed by the condensing coil, the air and droplet-shaped heat dissipation working medium flow to the gas-liquid separator through the outlet of the flow guide driving member; the gas-liquid separator separates the air from the droplet-shaped heat dissipation working medium, and the air is discharged upwards out of the box body, so that the pressure in the box body is adjusted to the first normal value; and if the cover plate is opened, it is determined whether the pressure in the box body is the second normal value; and if the pressure in the box body is not the second normal value, the flow guide driving member is controlled to operate; after the heat dissipation working medium flows towards the condensing coil and is condensed by the condensing coil, the air and droplet-shaped heat dissipation working medium flow to the gas-liquid separator through the outlet of the flow guide driving member; the gas-liquid separator separates the air from the droplet-shaped heat dissipation working medium, and the air is discharged upwards out of the box body, so that the pressure in the box body is adjusted to the second normal value. The arrangement manner above is able to maintain the pressure in the box body to be the normal value, thereby increasing the heat dissipation efficiency of the server.

Compared with conventional heat dissipation of the server, the device and method for controlling heat dissipation of a server provided in embodiments of the present invention are able to increase the condensation efficiency, thereby increasing the heat dissipation efficiency; in addition, the leakage of the fluorinated liquid when the cover of the box body is opened for maintenance of the server is able to be solved, so that not only the loss of the fluorinated liquid is able to be reduced, but also the problem of potential safety risks caused by the leakage of the fluorinated liquid is able to be solved, thereby improving the safety.

### Brief Description of the Drawings

In order to describe the technical solutions in the embodiments of the present invention or in the related art more clearly, hereinafter, accompanying drawings requiring to be used in the embodiments or the related art will be introduced briefly. Apparently, the accompanying drawings in the following description merely relate to embodiments of the present invention, and for a person of ordinary skill in the art, other accompanying drawings can also be obtained according to the provided accompanying drawings without involving any inventive effort.
Fig. 1 is a schematic diagram of an overall structure of a control device for a heat dissipation of a server with a cover not opened according to embodiments of the present invention;
Fig. 2 is a side view of the control device for a heat dissipation of a server as shown in Fig. 1;
Fig. 3 is a schematic diagram of heat dissipation of the control device for a heat dissipation of a server as shown in Fig. 2;
Fig. 4 is a schematic structural diagram of a condensing module in Fig. 2;
Fig. 5 is a top view of the control device for a heat dissipation of a server as shown in Fig. 1;
Fig. 6 is a front view of the control device for a heat dissipation of a server as shown in Fig. 1;
Fig. 7 is a schematic diagram of an overall structure of a control device for a heat dissipation of a server after a cover is opened according to embodiments of the present invention; and
Fig. 8 is a flowchart of a method for controlling heat dissipation of a server according to embodiments of the present invention.

In the drawings:
1 - control device for the heat dissipation of a server;
10 - Box body, 11 - Cover plate, 12 - Ventilation valve, 13 - Solenoid valve, 14 - Mechanical pressure relief valve, 15 - First pressure sensor, 16 - Second pressure sensor, 17 - Liquid level meter and temperature sensor;
101 - Heat dissipation working medium;
102 - Condensing module, 1021 - Condensing coil, 1022 - Flow guide driving member, 1023 - Gas-liquid separator, 10231 - First baffle plate, 10232 - Second baffle plate;
103 - Server.

### Detailed Description of the Embodiments

Hereinafter, the technical solutions in embodiments of the present invention will be described clearly and thoroughly with reference to the accompanying drawings of the embodiments of the present invention. Obviously, the embodiments as described are only some of the embodiments of the present invention, and are not all of the embodiments of the present invention. All other embodiments obtained by a person of ordinary skill in the art on the basis of the embodiments of the present invention without any inventive effort shall all fall within the scope of protection of the present invention.

The core of some embodiments of the present invention is to provide a control device for a heat dissipation of a server and a method for controlling heat dissipation of a server which is applied to the control device for the heat dissipation of the server, which is able to increase the heat dissipation efficiency, and solve the problems of loss due to leakage of a fluorinated liquid and potential safety risks when a cover of a box body is opened for maintenance of the server.

To make a person skilled in the art better understand the solutions of some embodiments of the present invention, hereinafter, some embodiments of the present invention are further described in detail with reference to the accompanying drawings and the specific embodiments.

It should be noted that, the orientation terms such as "upper end, lower end, left side and right side" described below are all defined on the basis of the drawings accompanying the description.

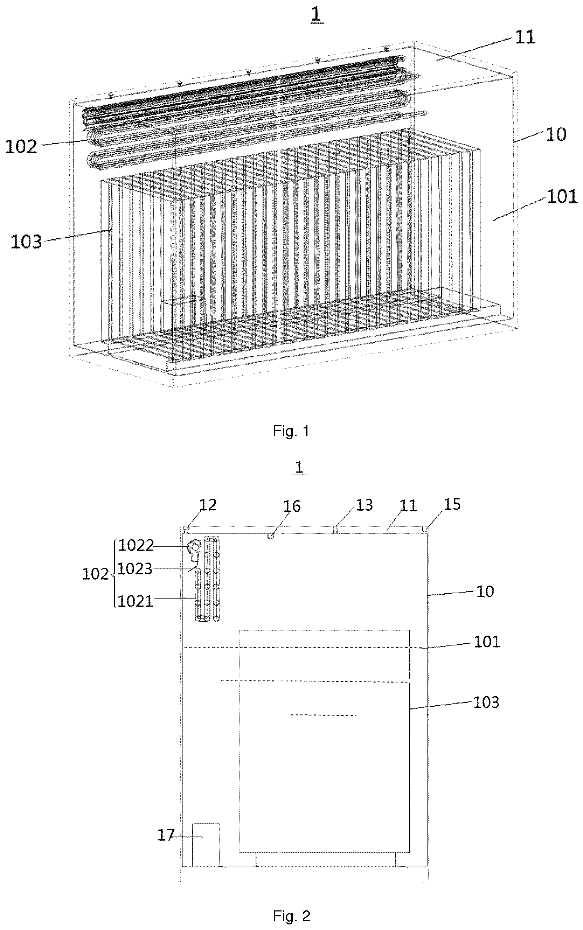

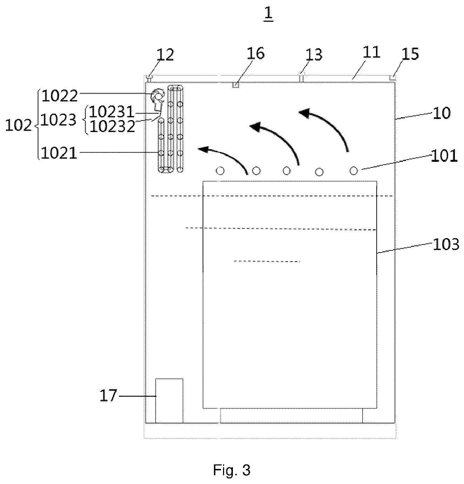

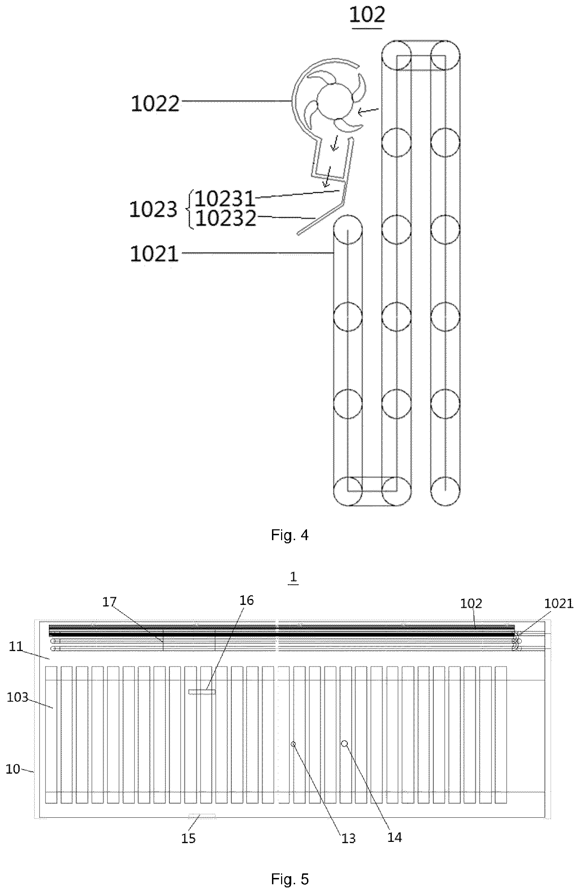

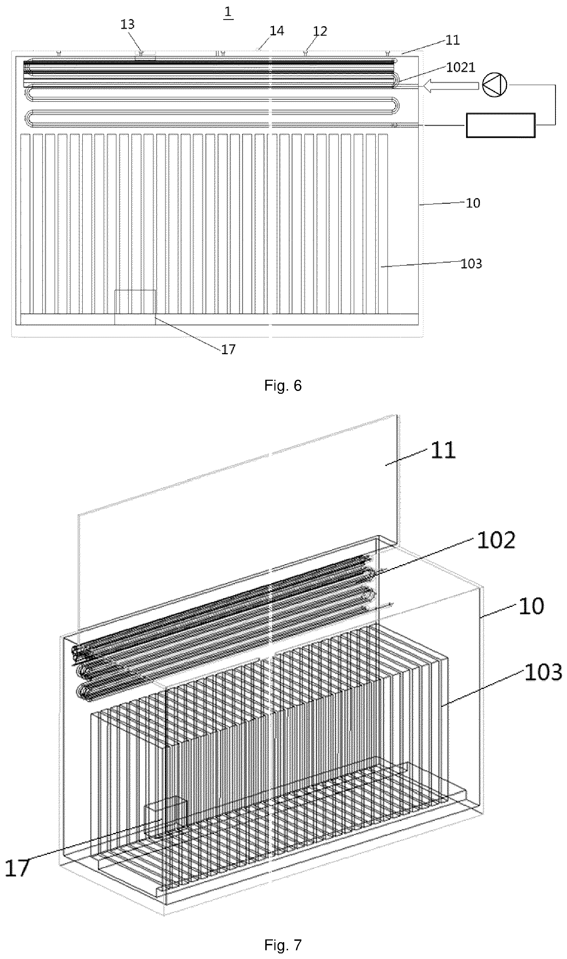

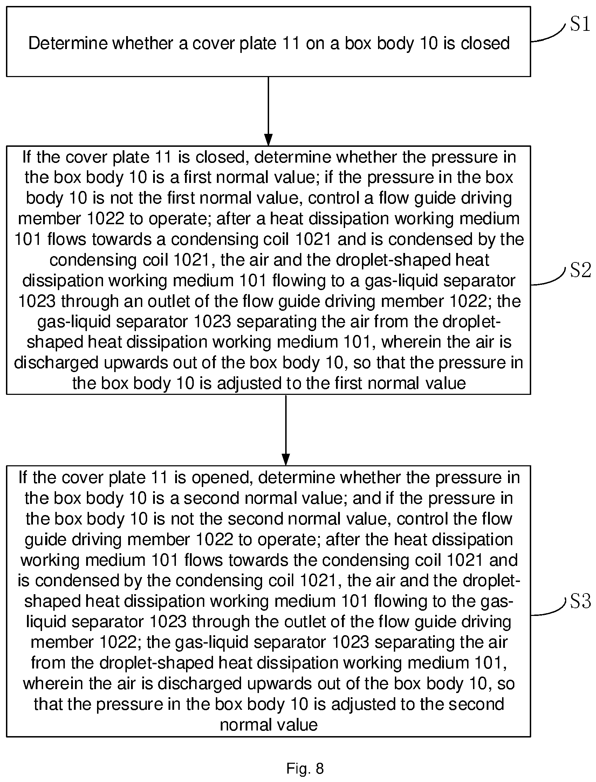

Please refer to Figs. 1-8, Fig. 1 is a schematic diagram of an overall structure of a control device for a heat dissipation of a server with a cover not opened according to embodiments of the present invention; Fig. 2 is a side view of the control device for a heat dissipation of a server as shown in Fig. 1; Fig. 3 is a schematic diagram of heat dissipation of the control device for a heat dissipation of a server as shown in Fig. 2; Fig. 4 is a schematic structural diagram of a condensation module in Fig. 2; Fig. 5 is a top view of the control device for a heat dissipation of a server as shown in Fig. 1; Fig. 6 is a front view of the control device for a heat dissipation of a server as shown in Fig. 1; Fig. 7 is a schematic diagram of an overall structure of a control device for a heat dissipation of a server after a cover is opened according to embodiments of the present invention; and Fig. 8 is a flowchart of a method for controlling heat dissipation of a server according to embodiments of the present invention.

The control device 1 for the heat dissipation of the server provided in embodiments of the present invention is configured for heat dissipation of the server 103. The device specifically includes a box body 10, a cover plate 11, a heat dissipation working medium 101 and a condensing module 102, wherein the server 103 is arranged in the box body 10, the cover plate 11 is connected with the box body 10, and the cover plate 11 is configured to close the box body 10 so as to improve an enclosed space for heat dissipation circulation of the server 103; the heat dissipation working medium 101 is arranged in the box body 10, and the server 103 is immersed in the heat dissipation working medium 101, and configured for heat dissipation of the server 103; and the condensing module 102 is arranged in the box body 10, and the condensing module 102 is configured to provide a condensing working condition, so that the heat dissipation working medium 101 in a gas state is condensed into a liquid after releasing heat.

In some embodiments, the heat dissipation working medium 101 may use a fluorinated liquid.

In some embodiments, the condensing module 102 specifically includes a condensing coil 1021 and a flow guide driving member 1022. The condensing coil 1021 is arranged in the box body 10, and the condensing coil 1021 is configured to assist phase change of the heat dissipation working medium 101, so as to achieve heat dissipation circulation. It should be noted that the phase change refers to a process in which the heat dissipation working medium 101 vaporized into a gas state is condensed into a liquid after releasing heat on the condensing coil 1021; the heat dissipation working medium 101 condensed into the liquid state falls back into the box body 10 under an action of gravity, thereby achieving the heat dissipation circulation; and the flow guide driving member 1022 is arranged towards the condensing coil 1021, and the flow guide driving member 1022 is configured to provide a driving force to control the heat dissipation working medium 101 in a steam/gas state to flow towards the condensing coil 1021.

In this way, the arrangement manner above is able to bring about many beneficial effects, specifically including: firstly, a gaseous heat dissipation working medium 101 is able to be sufficiently condensed on the condensing coil 1021, thereby greatly increasing the condensation efficiency; secondly, the gaseous heat dissipation working medium 101 is able to be prevented from impacting the cover plate 11 when the cover plate 11 is closed; if the heat dissipation working medium 101 impacts the cover plate 11 and then rebounds back and flows to the condensing module 102, the pressure loss will be increased, which is equivalent to increasing the temperature drop of the steam and indirectly decreasing the condensation efficiency, and therefore the gaseous heat dissipation working medium 101 is able to be prevented from impacting the cover plate 11, thereby further increasing the condensation efficiency; and thirdly, the gaseous heat dissipation working medium 101 is able to be prevented from leaking to an outside of the box body 10 when the cover plate 11 is opened; that is to say, a flowing direction of the heat dissipation working medium 101 is changed by the flow guide driving member 1022, so as to prevent the heat dissipation working medium 101 from leaking to the outside of the box body 10.

Compared with conventional heat dissipation of the server 103, the control device 1 for the heat dissipation of the server provided in embodiments of the present invention is able to increase the condensation efficiency, thereby increasing the heat dissipation efficiency; in addition, the leakage of the fluorinated liquid when a cover of the box body 10 is opened for maintenance of the server 103 is able to be solved, so that not only the loss of the fluorinated liquid is able to be reduced, but also the problem of potential safety risks caused by the leakage of the fluorinated liquid is able to be solved, thereby improving the safety.

Certainly, according to actual needs, the flow guide driving member 1022 may specifically be configured as a cross-flow fan, an axial-flow fan, or the like. According to application scenarios of the present invention, the cross-flow fan is adopted in some embodiments of the present invention.

It can be understood that, in cases where no cross-flow fan is provided, the driving force for gas flowing of the fluorinated liquid is derived from a pressure difference between a positive pressure of an evaporation zone and a negative pressure of a condensation zone on an upper part of the server 103. In consideration of the leakage problem, an inside of the box body 10 is under a normal pressure control, and the pressure difference cannot be too large; in this way, most of the steam may impact the cover plate 11 during rising inside the box body 10, and then rebound back and flow to the condensing module 102, which increases the pressure loss, which is equivalent to increasing a temperature drop of the steam and indirectly decreasing the condensation efficiency. When the cover of the box body 10 needs to be opened for maintenance, this problem may cause a gas of the fluorinated liquid to flow directly to the outside of the box body 10, thereby causing a great loss of the expensive fluorinated liquid, which not only causes an economic loss but also causes a potential safety hazard.

By the control device 1 for the heat dissipation of a two-phase immersion liquid-cooled server proposed in some embodiments of the present invention, with the provision of the condensing module 102, during normal operation, a main driving force for flowing of steam is provided by a suction force of the cross-flow fan, thereby preventing the steam from directly impacting the cover plate 11 upwards and then bouncing back and reducing the local loss during steam impacting and bouncing back; moreover, in cases where the condensation zone maintains the same pressure, the pressure in the evaporation zone is able to be reduced, that is, a boiling point of the fluorinated liquid is reduced, and finally a temperature of chips inside the server 103 is reduced. If a same chip temperature is maintained, a thermal flux density of the chips is able to be increased, i.e. a high heat dissipation density is achieved.

That is to say, the arrangement manner above is able to fundamentally solve the problem of a large loss of fluorinated liquid steam when the cover of the box body 10 is opened for maintenance, and is able to also greatly increase the condensation efficiency of a condenser, achieve a high heat dissipation density, and reduce the costs of a heat dissipation apparatus per unit of power consumption.

In some embodiments, the flow guide driving member 1022 is arranged on a side close to an inlet of the condensing coil 1021.

When the cover of the box body 10 is opened for maintenance, the pressure inside the box body 10 is controlled by adjusting an operating speed of the cross-flow fan, so as to achieve a balance of air pressures inside and outside the box body 10, thereby preventing the steam from leaking to the outside of the box body 10. In this case, the cross-flow fan is arranged at or near an inlet side of the condensing coil 1021, and as the condensation capability at this position is the strongest, a fluorinated liquid steam suctioned by the cross-flow fan is completely condensed in the condensing module 102, thereby greatly increasing the condensation efficiency.

In some embodiments, an accommodating space is formed between the condensing coil 1021 and a side wall of the box body 10, the flow guide driving member 1022 is arranged in the accommodating space, and the condensing coil 1021 covers the flow guide driving member 1022 in an arrangement direction of the server 103.

That is to say, the flow guide driving member 1022 is arranged between the condensing coil 1021 and the side wall of the box body 10. The server 103 is generally arranged vertically in the box body 10, and therefore, the condensing coil 1021 covers the flow guide driving member 1022 in a vertical direction, which is able to ensure that the condensation zone in the box body 10 is large enough and the flow guide driving member 1022 is covered by the condensation zone.

In some embodiments, the condensing coil 1021 is specifically a coil having an S-shaped cross section.

In some embodiments, the inlet of the condensing coil 1021 is connected with a first end of a condensing pipeline located outside the box body 10, the condensing pipeline is provided with refrigeration assemblies such as a pump and a compressor, and an outlet of the condensing coil 1021 is connected with a second end of the condensing pipeline located outside the box body 10; in this way, refrigeration circulation is able to be realized. The structure of the S-shaped coil is able to increase the condensation area, thereby greatly increasing the condensation efficiency in the box body 10.

Taking the condensing module 102 arranged on a single side as an example, after a system is put in, the fluorinated liquid absorbs the heat generated by the server 103, is vaporized into a fluorinated liquid gas when the liquid reaches a saturation temperature, releases heat on the condensing coil 1021 and is condensed into a liquid, and falls back to the inside of the box body 10 under the action of gravity, thereby realizing heat dissipation circulation. Certainly, the condensing module 102 may also be arranged on two sides of the server 103 according to actual requirements.

In order to ensure the stability of the operation of the system, the condensing module 102 further includes a gas-liquid separator 1023; the gas-liquid separator 1023 is provided at an outlet of the flow guide driving member 1022, and the gas-liquid separator 1023 is configured to separate an air and a droplet-shaped heat dissipation working medium 101. In some embodiments, the gas-liquid separator 1023 includes a first baffle plate 10231 and a second baffle plate 10232; the first baffle plate 10231 is connected with an outlet housing of the flow guide driving member 1022, and the second baffle plate 10232 is connected with the first baffle plate 10231 and is arranged at a preset included angle relative to the first baffle plate 10231. A range of the preset included angle is able to be adjusted according to an outlet angle of the cross-flow fan, and the range of the preset included angle is generally greater than 90°.

In this way, on a basis of providing the condensing coil 1021 and the cross-flow fan, some embodiments of the present invention realize gas-liquid separation by the gas-liquid separator 1023. In some embodiments, the fluorinated liquid steam suctioned by the cross-flow fan is completely condensed on the condensing module 102, and under the driving of the cross-flow fan, small-particle droplets of the fluorinated liquid and a small amount of air enter the fan from a side of the fan close to the condensing coil 1021; then the small-particle droplets of the fluorinated liquid and the small amount of air flow out along an outlet at a bottom of the fan under a driving action of fan blades, and the outlet at the bottom of the fan is a through hole, that is, an outlet position of the cross-flow fan mainly includes the small-particle droplets of the fluorinated liquid and the small amount of air, and baffle plates with a certain angle are provided at an outlet of the cross-flow fan. By using the principle of baffle separation, i.e. due to different densities of gas and liquid, when a mixed flow encounters an obstacle, the gas will be diverted and flow away; the liquid has a continuous forward speed due to inertia, the forward liquid is attached to a blocking wall surface of the baffle plate, and is gathered together downwards due to the action of gravity, and finally drops back to the inside of the box body 10 at a bottom of the second baffle plate 10232; however, the air will be diverted and flow upward due to the small density thereof, and is discharged to the outside of the box body 10 through a top of the box body 10, so that a pressure in the box body 10 is able to be always maintained at a normal value, which facilitates to ensure the stability of the operation of the system.

According to the invention, in order to facilitate air discharge, the control device for the heat dissipation of the server further includes a ventilation valve 12; the ventilation valve 12 is arranged at a bottom of the cover plate 11, and an air separated by the gas-liquid separator 1023 is discharged out of the box body 10 through the ventilation valve 12.

In some embodiments, the control device for the heat dissipation of the server further includes a pressure measurement assembly and a control assembly, wherein the pressure measurement assembly is arranged in the box body 10, and the pressure measurement assembly is configured to measure the pressure in the box body 10; the control assembly is connected with the pressure measurement assembly and the flow guide driving member 1022, and the control assembly is configured to control an operation of the flow guide driving member 1022 according to a pressure value measured by the pressure measurement assembly. The control assembly may be a PLC.

In some embodiments, the pressure measurement assembly may include a first pressure sensor 15 and a second pressure sensor 16; the first pressure sensor 15 is arranged between the cover plate 11 and the box body 10 or on the cover plate 11 and is configured to detect whether the cover plate 11 is in a closed state or an open state, and the second pressure sensor 16 is arranged at the bottom of the cover plate 11 and is configured to measure a pressure value in the box body 10; in addition, a liquid level meter and a temperature sensor 17 are further arranged inside the box body 10.

In some embodiments, the control device for the heat dissipation of the server further includes a pressure regulating valve; the pressure regulating valve is arranged on the cover plate 11 and is connected with the control assembly; the pressure regulating valve is configured to regulate the pressure inside the box body 10. For example, a solenoid valve 13 may be arranged at the bottom of the cover plate 11, and the solenoid valve 13 is controlled by the control assembly to achieve pressure regulation inside the box body 10. Of course, a mechanical safety valve (a mechanical pressure relief valve 14) may also be arranged on the bottom of the cover plate 11.

In addition, a method for controlling heat dissipation of a server provided by the embodiments of the present invention is applied to the control device 1 for the heat dissipation of the server, and includes:
S1: it is determined whether a cover plate 11 on a box body 10 is closed;
S2: if the cover plate 11 is closed, it is determined whether the pressure in the box body 10 is a first normal value; if the pressure in the box body 10 is not the first normal value, the flow guide driving member 1022 is controlled to operate; after the heat dissipation working medium 101 flows towards the condensing coil 1021 and is condensed by the condensing coil 1021, the air and droplet-shaped heat dissipation working medium 101 flow to the gas-liquid separator 1023 through the outlet of the flow guide driving member 1022; the gas-liquid separator 1023 separates the air from the droplet-shaped heat dissipation working medium 101, and the air is discharged upwards out of the box body 10, so that the pressure in the box body 10 is adjusted to the first normal value; and
S3: if the cover plate 11 is opened, it is determined whether the pressure in the box body 10 is a second normal value; and if the pressure in the box body 10 is not the second normal value, the flow guide driving member 1022 is controlled to operate; after the heat dissipation working medium 101 flows towards the condensing coil 1021 and is condensed by the condensing coil 1021, the air and droplet-shaped heat dissipation working medium 101 flow to the gas-liquid separator 1023 through the outlet of the flow guide driving member 1022; the gas-liquid separator 1023 separates the air from the droplet-shaped heat dissipation working medium 101, and the air is discharged upwards out of the box body 10, so that the pressure in the box body 10 is adjusted to the second normal value.

The arrangement manner above is able to maintain the pressure in the box body 10 to be the normal value, thereby increasing the heat dissipation efficiency of the server 103.

In some embodiments, the method for controlling heat dissipation of the server provided by the embodiments of the present invention specifically includes:
the system starts normally;
a data of the first pressure sensor 15 is acquired;
it is determined whether the cover plate 11 is closed according to the data detected by the first pressure sensor 15;
if the cover plate 11 is closed, a data of the second pressure sensor 16 is acquired, and it is determined whether the pressure in the box body 10 is the first normal value according to the data of the second pressure sensor 16; if the pressure in the box body 10 is not the first normal value, the flow guide driving member 1022 and/or the pressure regulating valve is controlled, so that the pressure in the box body 10 is adjusted to the first normal value; and
if the cover plate 11 is opened, a data of the second pressure sensor 16 is acquired, and it is determined whether the pressure in the box body 10 is the second normal value according to the data of the second pressure sensor 16; and if the pressure in the box body 10 is not the second normal value, the flow guide driving member 1022 is controlled, so that the pressure in the box body 10 is adjusted to the second normal value.

It should be noted that absolute values of the first normal value and the second normal value are different.

Certainly, before the step that the system starts normally, the method further includes: whether values of the liquid level meter and the temperature sensor in the box body 10 are normal, and if not, adjustment is performed until the values of the liquid level meter and the temperature sensor are both normal values.

It should be noted that in the present description, relational terms such as first and second, etc. are only used to distinguish one entity from several other entities, and do not necessarily require or imply any actual relationship or sequence between these entities.

Hereinabove, the device and method for controlling heat dissipation of a server provided in some embodiments of the present invention are described in detail. The principle and embodiments of the present invention are described herein by applying specific examples, and the illustration of the embodiments above is only used to help understand the solutions and core ideas of some embodiments of the present invention. It should be noted that, a person of ordinary skill in the art may further make several improvements and modifications to some embodiments of the present invention without departing from the principle of the present invention, which is defined in the appended claims.

## Claims

1. A control device for a heat dissipation of a server, configured for heat dissipation of the server (103) and comprising:
a box body (10);
a cover plate (11), connected with the box body (10) and configured to close the box body (10);
a heat dissipation working medium (101), arranged in the box body (10) and configured to immerse the server (103); and
a condensing module (102), arranged in the box body (10) and comprising:
a condensing coil (1021), arranged in the box body (10) and configured to assist phase change of the heat dissipation working medium (101), so as to achieve heat dissipation circulation;
**characterized in that**, the condensing module (102) further comprises:
a flow guide driving member (1022), arranged towards the condensing coil (1021) and configured to provide a driving force to control a gaseous heat dissipation working medium (101) to flow towards the condensing coil (1021), so as to prevent the gaseous heat dissipation working medium (101) from impacting the cover plate (11) when the cover plate (11) is closed and prevent the gaseous heat dissipation working medium (101) from leaking to an outside of the box body (10) when the cover plate (11) is opened;
wherein the condensing module (102) further comprises a gas-liquid separator (1023); the gas-liquid separator (1023) is arranged at an outlet of the flow guide driving member (1022), and the gas-liquid separator (1023) is configured to separate an air and a droplet-shaped heat dissipation working medium (101);
the device further comprises a ventilation valve (12), wherein the ventilation valve (12) is arranged on the cover plate (11), and an air separated by the gas-liquid separator (1023) is discharged out of the box body (10) through the ventilation valve (12).

2. The control device for the heat dissipation of the server as claimed in claim 1, wherein the flow guide driving member (1022) is arranged at a side close to an inlet of the condensing coil (1021).

3. The control device for the heat dissipation of the server as claimed in claim 2, wherein an accommodating space is formed between the condensing coil (1021) and the box body (10), the flow guide driving member (1022) is arranged in the accommodating space, and the condensing coil (1021) covers the flow guide driving member (1022) in an arrangement direction of the server (103).

4. The control device for the heat dissipation of the server as claimed in claim 1, wherein the condensing coil (1021) is an S-shaped coil.

5. The control device for the heat dissipation of the server as claimed in claim 1, wherein the gas-liquid separator (1023) comprises a first baffle plate (10231) and a second baffle plate (10232); the first baffle plate (10231) is connected with the flow guide driving member (1022), and the second baffle plate (10232) is connected with the first baffle plate (10231) and is arranged at a preset included angle relative to the first baffle plate (10231).

6. The control device for the heat dissipation of the server as claimed in any one of claims 1-4, further comprising:
a first pressure sensor (15), arranged between the cover plate (11) and the box body (10) and configured to detect a state of the cover plate (11);
a second pressure sensor (16), arranged on the cover plate (11) and configured to measure a pressure in the box body (10); and
a control assembly, connected with the first pressure sensor (15), the second pressure sensor (16) and the flow guide driving member (1022), and configured to control an operation of the flow guide driving member (1022) according to pressure values measured by the first pressure sensor (15) and the second pressure sensor (16).

7. The control device for the heat dissipation of the server as claimed in claim 6, wherein the device further comprises a pressure regulating valve, wherein the pressure regulating valve is arranged on the cover plate (11) and is connected with the control assembly, and the pressure regulating valve is configured to regulate the pressure inside the box body (10).

8. The control device for the heat dissipation of the server as claimed in claim 4, wherein an inlet of the condensing coil (1021) is connected with a first end of a condensing pipeline located outside the box body (10), the condensing pipeline is provided with a corresponding refrigeration assembly, and an outlet of the condensing coil (1021) is connected with a second end of the condensing pipeline located outside the box body (10).

9. The control device for the heat dissipation of the server as claimed in claim 5, wherein the condensing module (102) is arranged at two sides of the server (103), and a range of the preset included angle is greater than 90°.

10. A method for controlling heat dissipation of a server, applied to the control device for the heat dissipation of the server as claimed in claim 1 and comprising:
determining whether the cover plate (11) on the box body (10) is closed;
if the cover plate (11) is closed, determining whether a pressure in the box body (10) is a first normal value;
if it is determined that the pressure in the box body (10) is not the first normal value, controlling the flow guide driving member (1022) to operate; after the heat dissipation working medium (101) flows towards the condensing coil (1021) and is condensed by the condensing coil (1021), the air and the droplet-shaped heat dissipation working medium (101) flowing to the gas-liquid separator (1023) through the outlet of the flow guide driving member (1022); the gas-liquid separator (1023) separating the air from the droplet-shaped heat dissipation working medium (101), wherein the air is discharged upwards out of the box body (10), so that the pressure in the box body (10) is adjusted to the first normal value; and
if the cover plate (11) is opened, determining whether the pressure in the box body (10) is a second normal value; and
if it is determined that the pressure in the box body (10) is not the second normal value, controlling the flow guide driving member (1022) to operate; after the heat dissipation working medium (101) flows towards the condensing coil (1021) and is condensed by the condensing coil (1021), the air and the droplet-shaped heat dissipation working medium (101) flowing to the gas-liquid separator (1023) through the outlet of the flow guide driving member (1022); the gas-liquid separator (1023) separating the air from the droplet-shaped heat dissipation working medium (101), wherein the air is discharged upwards out of the box body (10), so that the pressure in the box body (10) is adjusted to the second normal value.

11. The method as claimed in claim 10, wherein the flow guide driving member (1022) is arranged at a side close to an inlet of the condensing coil (1021).

12. The method as claimed in claim 11, wherein an accommodating space is formed between the condensing coil (1021) and the box body (10), the flow guide driving member (1022) is arranged in the accommodating space, and the condensing coil (1021) covers the flow guide driving member (1022) in an arrangement direction of the server (103).

13. The method as claimed in claim 10, wherein the gas-liquid separator (1023) comprises a first baffle plate (10231) and a second baffle plate (10232); the first baffle plate (10231) is connected with the flow guide driving member (1022), and the second baffle plate (10232) is connected with the first baffle plate (10231) and is arranged at a preset included angle relative to the first baffle plate (10231).

14. The method as claimed in any one of claims 10-12, further comprising:
a first pressure sensor (15), arranged between the cover plate (11) and the box body (10) and configured to detect a state of the cover plate (11);
a second pressure sensor (16), arranged on the cover plate (11) and configured to measure the pressure in the box body (10); and
a control assembly, connected with the first pressure sensor (15), the second pressure sensor (16) and the flow guide driving member (1022), and configured to control the operation of the flow guide driving member (1022) according to pressure values measured by the first pressure sensor (15) and the second pressure sensor (16).

## Patentansprüche

1. Steuervorrichtung für eine Wärmeableitung eines Servers, die zur Wärmeableitung des Servers (103) konfiguriert ist und Folgendes umfasst:
einen Kastenkörper (10);
eine Abdeckplatte (11), die mit dem Kastenkörper (10) verbunden und dazu konfiguriert ist, den Kastenkörper (10) zu schließen;
ein Wärmeableitungsarbeitsmedium (101), das in dem Kastenkörper (10) angeordnet und dazu konfiguriert ist, den Server (103) einzutauchen; und
ein Kondensiermodul (102), das in dem Kastenkörper (10) angeordnet ist und Folgendes umfasst:
eine Kondensierschlange (1021), die in dem Kastenkörper (10) angeordnet und dazu konfiguriert ist, einen Phasenwechsel des Wärmeableitungsarbeitsmedium (101) zu unterstützen, um so eine Wärmeableitungszirkulation zu erreichen;
**gekennzeichnet dadurch, dass** das Kondensiermodul (102) ferner Folgendes umfasst:
ein Strömungsführungsantriebselement (1022), das zu der Kondensierschlange (1021) hin angeordnet und dazu konfiguriert ist, eine Antriebskraft bereitzustellen, um ein gasförmiges Wärmeableitungsarbeitsmedium (101) dazu zu steuern, zu der Kondensierschlange (1021) hin zu strömen, um so zu verhindern, dass das gasförmige Wärmeableitungsarbeitsmedium (101) auf die Abdeckplatte (11) trifft, wenn die Abdeckplatte (11) geschlossen ist und zu verhindern, dass das gasförmige Wärmeableitungsarbeitsmedium (101) auf eine Außenseite des Kastenkörpers (10) austritt, wenn die Abdeckplatte (11) geöffnet ist;
wobei das Kondensiermodul (102) ferner einen Gas-Flüssigkeitsabscheider (1023) umfasst; wobei der Gas-Flüssigkeitsabscheider (1023) an einem Auslass des Strömungsführungsantriebselements (1022) angeordnet ist, und der Gas-Flüssigkeitsabscheider (1023) dazu konfiguriert ist, Luft und ein tröpfchenförmiges Wärmeabscheidungsarbeitsmedium (101) abzuscheiden;
wobei die Vorrichtung ferner ein Entlüftungsventil (12) umfasst, wobei das Entlüftungsventil (12) auf der Abdeckplatte (11) angeordnet ist, und eine von dem Gas-Flüssigkeitsabscheider (1023) abgeschiedene Luft aus dem Kastenkörper (10) durch das Entlüftungsventil (12) abgeführt wird.

2. Steuervorrichtung für die Wärmeableitung des Servers wie in Anspruch 1 beansprucht, wobei das Strömungsführungsantriebselement (1022) an einer Seite nahe zu einem Einlass der Kondensierschlange (1021) angeordnet ist.

3. Steuervorrichtung für die Wärmeableitung des Servers wie in Anspruch 2 beansprucht, wobei ein Aufnahmeraum zwischen der Kondensierschlange (1021) und dem Kastenkörper (10) ausgebildet ist, das Strömungsführungsantriebselement (1022) in dem Aufnahmeraum angeordnet ist und die Kondensierschlange (1021) das Strömungsführungsantriebselement (1022) in einer Anordnungsrichtung des Servers (103) abdeckt.

4. Steuervorrichtung für die Wärmeableitung des Servers wie in Anspruch 1 beansprucht, wobei die Kondensierschlange (1021) eine S-förmige Schlange ist.

5. Steuervorrichtung für die Wärmeableitung des Servers wie in Anspruch 1 beansprucht, wobei der Gas-Flüssigkeitsabscheider (1023) eine erste Ablenkplatte (10231) und eine zweite Ablenkplatte (10232) umfasst; wobei die erste Ablenkplatte (10231) mit dem Strömungsführungsantriebselement (1022) verbunden ist und die zweite Ablenkplatte (10232) mit der ersten Ablenkplatte (10231) verbunden ist und an einem voreingestellten eingeschlossenen Winkel relativ zu der ersten Ablenkplatte (10231) angeordnet ist.

6. Steuervorrichtung für die Wärmeableitung des Servers wie in einem der Ansprüche 1 bis 4 beansprucht, ferner umfassend:
einen ersten Drucksensor (15), der zwischen der Abdeckplatte (11) und dem Kastenkörper (10) angeordnet und dazu konfiguriert ist, einen Zustand der Abdeckplatte (11) zu erkennen;
einen zweiten Drucksensor (16), der an der Abdeckplatte (11) angeordnet und dazu konfiguriert ist, einen Druck in dem Kastenkörper (10) zu messen; und
eine Steuerbaugruppe, die mit dem ersten Drucksensor (15), dem zweiten Drucksensor (16) und dem Strömungsführungsantriebselement (1022) verbunden ist und dazu konfiguriert ist, einen Betrieb des Strömungsführungsantriebselements (1022) gemäß Druckwerten zu steuern, die von dem ersten Drucksensor (15) und dem zweiten Drucksensor (16) gemessen werden.

7. Steuervorrichtung für die Wärmeableitung des Servers wie in Anspruch 6 beansprucht, wobei die Vorrichtung ferner ein Druckregelventil umfasst, wobei das Druckregelventil auf der Abdeckplatte (11) angeordnet und mit der Steuerbaugruppe verbunden ist, und das Druckregelventil dazu konfiguriert ist, den Druck im Inneren des Kastenkörpers (10) zu regeln.

8. Steuervorrichtung für die Wärmeableitung des Servers wie in Anspruch 4 beansprucht, wobei ein Einlass der Kondensierschlange (1021) mit einem ersten Ende einer Kondensierleitung, die sich auf der Außenseite des Kastenkörpers (10) befindet, verbunden ist, wobei die Kondensierleitung mit einer entsprechenden Kältebaugruppe bereitgestellt ist und ein Auslass der Kondensierschlange (1021) mit einem zweiten Ende der Kondensierleitung, die sich auf der Außenseite des Kastenkörpers (10) befindet, verbunden ist.

9. Steuervorrichtung für die Wärmeableitung des Servers wie in Anspruch 5 beansprucht, wobei das Kondensiermodul (102) an zwei Seiten des Servers (103) angeordnet ist und ein Bereich des voreingestellten eingeschlossenen Winkels größer als 90° ist.

10. Verfahren zum Steuern einer Wärmeableitung eines Servers, das auf die Steuervorrichtung für die Wärmeableitung des Servers, wie in Anspruch 1 beansprucht, angewendet wird und Folgendes umfasst:
Bestimmen, ob die Abdeckplatte (11) auf dem Kastenkörper (10) geschlossen ist;
wenn die Abdeckplatte (11) geschlossen ist, Bestimmen, ob ein Druck in dem Kastenkörper (10) ein erster Normalwert ist;
wenn bestimmt wird, dass der Druck in dem Kastenkörper (10) nicht der erste Normalwert ist, Steuern des Strömungsführungsantriebselements (1022) dazu, dass es betrieben wird; nachdem das Wärmeableitungsarbeitsmedium (101) zu der Kondensierschlange (1021) hin strömt und von der Kondensierschlange (1021) kondensiert wird, Strömen der Luft und des tröpfchenförmigen Wärmeableitungsarbeitsmediums (101) durch den Auslass des Strömungsführungsantriebselements (1022) zu dem Gas-Flüssigkeitsabscheider (1023); Abscheiden, durch den Gas-Flüssigkeitsabscheider (1023), der Luft von dem tröpfchenförmigen Wärmeableitungsarbeitsmedium (101), wobei die Luft nach oben aus dem Kastenkörper (10) hinaus abgeführt wird, sodass der Druck in dem Kastenkörper (10) auf den ersten Normalwert angepasst wird; und
wenn die Abdeckplatte (11) geöffnet ist, Bestimmen, ob der Druck in dem Kastenkörper (10) ein zweiter Normalwert ist; und
wenn bestimmt wird, dass der Druck in dem Kastenkörper (10) nicht der zweite Normalwert ist, Steuern des Strömungsführungsantriebselements (1022) dazu, dass es betrieben wird; nachdem das Wärmeableitungsarbeitsmedium (101) zu der Kondensierschlange (1021) hin strömt und von der Kondensierschlange (1021) kondensiert wird, Strömen der Luft und des tröpfchenförmigen Wärmeableitungsarbeitsmediums (101) durch den Auslass des Strömungsführungsantriebselements (1022) zu dem Gas-Flüssigkeitsabscheider (1023); Abscheiden, durch den Gas-Flüssigkeitsabscheider (1023), der Luft von dem tröpfchenförmigen Wärmeableitungsarbeitsmedium (101), wobei die Luft nach oben aus dem Kastenkörper (10) hinaus abgeführt wird, sodass der Druck in dem Kastenkörper (10) auf den zweiten Normalwert angepasst wird; und

11. Verfahren wie in Anspruch 10 beansprucht, wobei das Strömungsführungsantriebselement (1022) an einer Seite nahe zu einem Einlass der Kondensierschlange (1021) angeordnet ist.

12. Verfahren wie in Anspruch 11 beansprucht, wobei ein Aufnahmeraum zwischen der Kondensierschlange (1021) und dem Kastenkörper (10) ausgebildet ist, das Strömungsführungsantriebselement (1022) in dem Aufnahmeraum angeordnet ist und die Kondensierschlange (1021) das Strömungsführungsantriebselement (1022) in einer Anordnungsrichtung des Servers (103) abdeckt.

13. Verfahren wie in Anspruch 10 beansprucht, wobei der Gas-Flüssigkeitsabscheider (1023) eine erste Ablenkplatte (10231) und eine zweite Ablenkplatte (10232) umfasst; wobei die erste Ablenkplatte (10231) mit dem Strömungsführungsantriebselement (1022) verbunden ist und die zweite Ablenkplatte (10232) mit der ersten Ablenkplatte (10231) verbunden ist und an einem voreingestellten eingeschlossenen Winkel relativ zu der ersten Ablenkplatte (10231) angeordnet ist.

14. Verfahren wie in einem der Ansprüche 10 bis 12 beansprucht, ferner umfassend:
einen ersten Drucksensor (15), der zwischen der Abdeckplatte (11) und dem Kastenkörper (10) angeordnet und dazu konfiguriert ist, einen Zustand der Abdeckplatte (11) zu erkennen;
einen zweiten Drucksensor (16), der an der Abdeckplatte (11) angeordnet und dazu konfiguriert ist, den Druck in dem Kastenkörper (10) zu messen; und
eine Steuerbaugruppe, die mit dem ersten Drucksensor (15), dem zweiten Drucksensor (16) und dem Strömungsführungsantriebselement (1022) verbunden ist und dazu konfiguriert ist, den Betrieb des Strömungsführungsantriebselements (1022) gemäß Druckwerten zu steuern, die von dem ersten Drucksensor (15) und dem zweiten Drucksensor (16) gemessen werden.

## Revendications

1. Dispositif de commande d'une dissipation de chaleur d'un serveur, configuré pour la dissipation de chaleur du serveur (103) et comprenant :
un corps de boîtier (10) ;
une plaque de recouvrement (11), reliée au corps de boîtier (10) et configurée pour fermer le corps de boîtier (10) ;
un milieu de travail de dissipation de chaleur (101), agencé dans le corps de boîtier (10) et configuré pour immerger le serveur (103) ; et
un module de condensation (102), agencé dans le corps de boîtier (10) et comprenant :
un serpentin de condensation (1021), agencé dans le corps de boîtier (10) et configuré pour assister le changement de phase du milieu de travail de dissipation de chaleur (101), afin de réaliser une circulation de dissipation de chaleur ;
**caractérisé en ce que** le module de condensation (102) comprend en outre :
un élément d'entraînement de guide d'écoulement (1022), agencé vers le serpentin de condensation (1021) et configuré pour fournir une force d'entraînement pour commander à un milieu de travail de dissipation de chaleur gazeux (101) de s'écouler vers la serpentin de condensation (1021), afin d'empêcher le milieu de travail de dissipation de chaleur gazeux (101) d'impacter la plaque de recouvrement (11) lorsque la plaque de recouvrement (11) est fermée et d'empêcher le milieu de travail de dissipation de chaleur gazeux (101) de s'échapper vers l'extérieur du corps de boîtier (10) lorsque la plaque de recouvrement (11) est ouverte ;
dans lequel le module de condensation (102) comprend en outre un séparateur gaz-liquide (1023) ; le séparateur gaz-liquide (1023) est agencé au niveau d'une sortie de l'élément d'entraînement de guide d'écoulement (1022), et le séparateur gaz-liquide (1023) est configuré pour séparer un air et un milieu de travail de dissipation de chaleur (101) sous forme de gouttelettes ;
le dispositif comprend en outre une vanne de ventilation (12), dans lequel la vanne de ventilation (12) est agencée sur la plaque de recouvrement (11), et un air séparé par le séparateur gaz-liquide (1023) est évacué du corps de boîtier (10) par la vanne de ventilation (12).

2. Dispositif de commande de dissipation de chaleur de serveur selon la revendication 1, dans lequel l'élément d'entraînement de guide d'écoulement (1022) est agencé au niveau d'un côté proche d'une entrée du serpentin de condensation (1021).

3. Dispositif de commande de dissipation de chaleur de serveur selon la revendication 2, dans lequel un espace de logement est formé entre le serpentin de condensation (1021) et le corps de boîtier (10), l'élément d'entraînement de guide d'écoulement (1022) est agencé dans l'espace de logement, et le serpentin de condensation (1021) recouvre l'élément d'entraînement de guide d'écoulement (1022) dans une direction d'agencement du serveur (103).

4. Dispositif de commande de dissipation de chaleur de serveur selon la revendication 1, dans lequel le serpentin de condensation (1021) est un serpentin en forme de S.

5. Dispositif de commande de dissipation de chaleur de serveur selon la revendication 1, dans lequel le séparateur gaz-liquide (1023) comprend une première plaque déflectrice (10231) et une deuxième plaque déflectrice (10232) ; la première plaque déflectrice (10231) est reliée à l'élément d'entraînement de guide d'écoulement (1022), et la deuxième plaque déflectrice (10232) est reliée à la première plaque déflectrice (10231) et est agencée à un angle inclus prédéfini par rapport à la première plaque déflectrice (10231).

6. Dispositif de commande de dissipation de chaleur de serveur selon l'une quelconque des revendications 1 à 4, comprenant en outre :
un premier capteur de pression (15), agencé entre la plaque de recouvrement (11) et le corps de boîtier (10) et configuré pour détecter un état de la plaque de recouvrement (11) ;
un deuxième capteur de pression (16), agencé sur la plaque de recouvrement (11) et configuré pour mesurer une pression dans le corps de boîtier (10) ; et
un ensemble de commande, relié au premier capteur de pression (15), au deuxième capteur de pression (16) et à l'élément d'entraînement de guide d'écoulement (1022), et configuré pour commander un fonctionnement de l'élément d'entraînement de guide d'écoulement (1022) en fonction de valeurs de pression mesurées par le premier capteur de pression (15) et le deuxième capteur de pression (16).

7. Dispositif de commande de dissipation de chaleur de serveur selon la revendication 6, dans lequel le dispositif comprend en outre une vanne de régulation de pression, dans lequel la vanne de régulation de pression est agencée sur la plaque de recouvrement (11) et est reliée à l'ensemble de commande, et la vanne de régulation de pression est configurée pour réguler la pression à l'intérieur du corps de boîtier (10).

8. Dispositif de commande de dissipation de chaleur de serveur selon la revendication 4, dans lequel une entrée du serpentin de condensation (1021) est reliée à une première extrémité d'une conduite de condensation située à l'extérieur du boîtier (10), la conduite de condensation est pourvue d'un ensemble de réfrigération correspondant, et une sortie du serpentin de condensation (1021) est reliée à une deuxième extrémité de la conduite de condensation située à l'extérieur du boîtier (10).

9. Dispositif de commande de dissipation de chaleur de serveur selon la revendication 5, dans lequel le module de condensation (102) est agencé des deux côtés du serveur (103), et une plage de l'angle inclus prédéfini est supérieure à 90°.

10. Procédé de commande de dissipation de chaleur d'un serveur, appliqué au dispositif de commande de dissipation de chaleur de serveur selon la revendication 1 et comprenant :
le fait de déterminer si la plaque de recouvrement (11) sur le corps de boîtier (10) est fermée ;
si la plaque de recouvrement (11) est fermée, le fait de déterminer si une pression dans le corps de boîtier (10) est une première valeur normale ;
s'il est déterminé que la pression dans le corps de boîtier (10) n'est pas la première valeur normale, le fait de commander à l'élément d'entraînement de guide d'écoulement (1022) de fonctionner, après que le milieu de travail de dissipation de chaleur (101) s'écoule vers le serpentin de condensation (1021) et est condensé par le serpentin de condensation (1021), l'air et le milieu de travail de dissipation de chaleur (101) s'écoulant vers le séparateur gaz-liquide (1023) par la sortie de l'élément d'entraînement de guide d'écoulement (1022) ; le séparateur gaz-liquide (1023) séparant l'air du milieu de travail de dissipation de chaleur (101), dans lequel l'air est évacué vers le haut hors du corps de boîtier (10), afin que la pression dans le corps de boîtier (10) soit ajustée à la première valeur normale ; et
si la plaque de recouvrement (11) est ouverte, le fait de déterminer si la pression dans le corps de boîtier (10) est une deuxième valeur normale ; et
s'il est déterminé que la pression dans le corps de boîtier (10) n'est pas la deuxième valeur normale, le fait de commander à l'élément d'entraînement de guide d'écoulement (1022) de fonctionner ; après que le milieu de travail de dissipation de chaleur (101) s'écoule vers le serpentin de condensation (1021) et est condensé par le serpentin de condensation (1021), l'air et le milieu de travail de dissipation de chaleur (101) sous forme de gouttelettes s'écoulant vers le séparateur gaz-liquide (1023) par la sortie de l'élément d'entraînement de guide d'écoulement (1022) ; le séparateur gaz-liquide (1023) séparant l'air du milieu de travail de dissipation de chaleur (101) sous forme de gouttelettes, dans lequel l'air est évacué vers le haut hors du corps de boîtier (10), afin que la pression dans le corps de boîtier (10) soit ajustée à la deuxième valeur normale.

11. Procédé selon la revendication 10, dans lequel l'élément d'entraînement de guide d'écoulement (1022) est agencé au niveau d'un côté proche d'une entrée du serpentin de condensation (1021).

12. Procédé selon la revendication 11, dans lequel un espace de logement est formé entre le serpentin de condensation (1021) et le corps de boîtier (10), l'élément d'entraînement de guide d'écoulement (1022) est agencé dans l'espace de logement, et le serpentin de condensation (1021) recouvre l'élément d'entraînement de guide d'écoulement (1022) dans une direction d'agencement du serveur (103).

13. Procédé selon la revendication 10, dans lequel le séparateur gaz-liquide (1023) comprend une première plaque déflectrice (10231) et une deuxième plaque déflectrice (10232) ; la première plaque déflectrice (10231) est reliée à l'élément d'entraînement de guide d'écoulement (1022), et la deuxième plaque déflectrice (10232) est reliée à la première plaque déflectrice (10231) et est agencée à un angle inclus prédéfini par rapport à la première plaque déflectrice (10231).

14. Procédé selon l'une quelconque des revendications 10 à 12, comprenant en outre :
un premier capteur de pression (15), agencé entre la plaque de recouvrement (11) et le corps de boîtier (10) et configuré pour détecter un état de la plaque de recouvrement (11) ;
un deuxième capteur de pression (16), agencé sur la plaque de recouvrement (11) et configuré pour mesurer la pression dans le corps de boîtier (10) ; et
un ensemble de commande, relié au premier capteur de pression (15), au deuxième capteur de pression (16) et à l'élément d'entraînement de guide d'écoulement (1022), et configuré pour commander le fonctionnement de l'élément d'entraînement de guide d'écoulement (1022) en fonction des valeurs de pression mesurées par le premier capteur de pression (15) et le deuxième capteur de pression (16).
